# EUROPÄISCHE PATENTSCHRIFT

(11) **EP 1 712 655 B1**
(45) Veröffentlichungstag und Bekanntmachung des Hinweises auf die Patenterteilung: **03.03.2010**
(21) Anmeldenummer: 05007933.4
(22) Anmeldetag: 12.04.2005
(51) Int. Cl.: C23C 14/34

(54) **Vorrichtung zur Plasmabehandlung und/oder zur Beschichtung von Werkstücken**
Apparatus for plasma treatment and/or coating of a work piece
Appareil de traitement par plasma et/ou pour rêvetir une pièce

(43) Veröffentlichungstag der Anmeldung: 18.10.2006
(73) Patentinhaber: Hauzer Techno-Coating B.V., 5928 LL Venlo (NL)
(72) Erfinder: Tietema, Roel, 5926 SK Venlo (NL); Doerwald, Dave, 6532 CG Nijmegen (NL); Gubbels, Roger J.H., 5927 PD Venlo (NL); Kaland, Anthonie J.A., 5612 DJ Eindhoven (NL)
(74) Vertreter: Stenger, Watzke & Ring

(56) Entgegenhaltungen:
- EP-A- 0 489 239
- "TRIODE SPUTTERING APPARATUS" IBM TECHNICAL DISCLOSURE BULLETIN, IBM CORP. NEW YORK, US, Bd. 32, Nr. 8A, Januar 1990 (1990-01), Seiten 85-87, XP000082715 ISSN: 0018-8689
- KASPI R ET AL: "GROWTH OF INGAASSB LAYERS IN THE MISCIBILITY GAP: USE OF VERY-LOW-ENERGY ION IRRADIATION TO REDUCE ALLOY DECOMPOSITION" JOURNAL OF VACUUM SCIENCE AND TECHNOLOGY: PART B, AMERICAN INSTITUTE OF PHYSICS. NEW YORK, US, Bd. 13, Nr. 3, Mai 1995 (1995-05), Seiten 978-987, XP000537378 ISSN: 1071-1023

## Beschreibung

Die Erfindung betrifft eine Vorrichtung zur Plasma- und/oder Beschichtungsbehandlung von Werkstücken mit einer evakuierbaren Kammer, einer innerhalb der Kammer drehbar angeordneten Halteeinrichtung für die zu behandelnden Werkstücke und einer Plasmaquelle, wobei die Plasmaquelle innerhalb der Kammer angeordnet ist, zu welchem Zweck die mindestens eine Kathode und die mindestens eine Anode der Plasmaquelle ober- bzw. unterseitig innerhalb der Kammer angeordnet sind.

Bekannt geworden ist eine derartige Vorrichtung beispielsweise aus der EP 0 489 239 A1 oder der EP 0 413 853 B1. Die mit der EP 0 413 853 B1 beschriebene Vorrichtung umfaßt eine evakuierbare Bearbeitungskammer mit einer innerhalb der Bearbeitungskammer angeordneten Werkstückhalterung. Die Werkstückhalterung ist um die zentrale Achse der Bearbeitungskammer rotierbar ausgebildet und dient der Aufnahme der zu behandelnden Werkstücke. Außerhalb der Bearbeitungskammer ist an deren Oberseite eine Kathodenkammer angeordnet, die unter Zusammenwirkung mit einer an der Unterseite der Bearbeitungskammer vorgesehenen Anode die Ausbildung einer Niedervoltbogenentladung längs der Zentralachse der Bearbeitungskammer ermöglicht. Die Kathodenkammer ist von der Bearbeitungskammer über Isolatoren getrennt und steht über eine Blende, welche eine kleine Öffnung aufweist, mit der Bearbeitungskammer in Verbindung. Vorgesehen sind des weiteren Magnetronzerstäubungsquellen, die von außen an die Kammerwand der Bearbeitungskammer angeflanscht sind.

Für den Betrieb der Niedervoltbogenentladung wird die Kathode mit einem Heizstromversorgungsgerät geheizt, so daß die Kathode Elektronen imitiert. Zwischen der Kathode und der Anode ist eine weitere Stromversorgung für den Betrieb der Bogenentladung vorgesehen.

Die Werkstückhalterung zur Aufnahme der zu behandelnden Werkstücke ist vorzugsweise rotationssymmetrisch ausgebildet und zwischen Bogenentladung einerseits und Kammerwand der Bearbeitungskammer andererseits angeordnet, so daß die von der Werkstückhalterung aufgenommenen Werkstücke um die Zentralachse der Bearbeitungskammer rotierend bewegt werden können. Die Kathodenkammer verfügt vorzugsweise über einen Gaseinlaß, über welchen die Kathodenkammer mit einem Arbeitsgas, beispielsweise Argon, versorgt werden kann, so daß die zu behandelnden Werkstücke mittels der Niedervoltbogenentladung sowohl einem Elektronenbeschuß als auch einem Ionenbeschuß ausgesetzt werden können. Durch das Anlegen einer negativen Spannung an die zu behandelnden Werkstücke findet ein Ionenbeschuß statt, wohingegen bei Anlegen einer positiven Spannung an die zu behandelnden Werkstücke ein Elektronenbeschuß der Werkstücke möglich ist. Einem Beschichtungsvorgang vorausgehend können die Werkstücke mithin mittels der Plasmaquelle vorbehandelt werden, einerseits bei Elektronenbeschuß durch Reinigung und Aufheizen und andererseits bei Ionenbeschuß durch Zerstäubungsätzen. Im Anschluß an eine solche Vorbehandlung können die Werkstücke durch Bestäuben mittels der Magnetronzerstäubungsquellen beschichtet werden.

Von Nachteil bei der vorbeschriebenen Vorrichtung ist, daß sie nicht zur Behandlung auch großer Werkstücke geeignet ist. Bedingt durch den zentral durch die Behandlungskammer verlaufenden Elektronenstrahl der Plasmaquelle kann als effektiver Behandlungsraum für die Werkstücke lediglich der sich zwischen Elektronenstrahl und Kammerwand ergebende Ringraum genutzt werden. Damit ist die Größe der mit der vorbekannten Vorrichtung behandelbaren Werkstücke auf die durch den Ringraum gegebenen Abmessungen begrenzt. Obgleich die Bearbeitungskammer dem Grunde nach auch größere Werkstücke aufnehmen könnte, ist eine Behandlung derselben als Folge der in bezug auf die Behandlungskammer zentralen Ausrichtung des Elektronenstrahls der Plasmaquelle nicht möglich.

Um den vorgenannten Nachteil zu überwinden wurde mit der EP 0 886 880 B1 eine Anlage zur Beschichtung von Werkstücken vorgeschlagen, gemäß welcher die die Plasmaquelle bildende Kathoden-Anoden-Anordnung außerhalb der Behandlungskammer seitlich an dieser angeordnet ist. Erreicht wird durch diese Anordnung, daß der von der Behandlungskammer umschlossene Volumenraum nahezu vollständig zur Behandlung von Werkstücken zur Verfügung steht, so daß im Unterschied zur EP 0 413 853 B1 bei gleich großer Behandlungskammer größere Werkstücke behandelt werden können. Erkauft wird dieser Vorteil jedoch damit, daß die Vorrichtung als solche in ihren geometrischen Ausmaßen wächst, denn ist die Kathoden-Anoden-Anordnung gemäß der EP 0 886 880 B1 außenumfangsseitig an der Behandlungskammer angeflanscht. Damit wird nicht nur die Vorrichtung als solche größer und damit unhandlicher, auch geht durch die Außenanordnung der Kathodenkammer wertvoller Raum für die Anordnung von Zerstäubungsquellen verloren. Zudem ist von Nachteil, daß die Kathodenkammer aufgrund des Umstandes, daß die Niedervoltbogenanordnung mindestens 10 cm von den zu behandelnden Werkstücken zu beabstanden ist, sehr ausladend und großvolumig auszubilden ist. Damit mögen zwar mit der Vorrichtung gemäß der EP 0 886 880 B1 größere Werkstücke als mit der Vorrichtung gemäß der EP 0 413 853 B1 behandelt werden können, doch erfordert dies trotz gleichbleibend großer Behandlungskammer eine insgesamt größer ausgebildete Vorrichtung.

**Aufgabe** der Erfindung ist es, unter Vermeidung der vorgenannten Nachteile eine Vorrichtung zur Plasma- und/oder Beschichtungsbehandlung von Werkstücken vorzuschlagen, die bei gleichzeitiger Verhinderung einer ungewollten Lichtbogenzündung die Beschichtung von im Vergleich zur Vorrichtungsgröße relativ großen Werkstücken ermöglicht. Auch soll mit der Erfindung ein Verfahren zur Plasma- und/oder Beschichtungsbehandlung von Werkstücken vorgeschlagen werden.

**Gelöst** wird diese Aufgabe durch eine Vorrichtung, die dadurch gekennzeichnet ist, daß die Kathode und die Anode an eine gemeinsame Stromquelle angeschlossen sind, wobei zur Unterbrechung des Kathoden-Anoden-Stromkreises ein Stromunterbrecher vorgesehen ist.

Die erfindungsgemäße Vorrichtung zeichnet sich dadurch aus, daß die die Plasmaquelle ausbildende Kathoden-Anoden-Anordnung innerhalb der Behandlungskammer angeordnet ist. Anders als aus dem Stand der Technik bekannt, wird auf die Ausbildung einer großvolumigen Kathodenkammer außerhalb des Behandlungsraumes verzichtet, so daß die Vorrichtung als solche eine insgesamt kompakte Bauform aufweist. Von Vorteil ist ferner, daß der gesamte umfangsseitige Bereich der Behandlungskammer zur Anordnung von Beschichtungsquellen zur Verfügung steht. Die Anordnung derartiger Beschichtungsquellen wird nicht durch außerhalb der Behandlungskammer vorgesehene Kathoden-Anoden-Anordnungen behindert, wie dies beim Stand der Technik der Fall ist.

Angeordnet sind die mindestens eine Kathode und die mindestens eine Anode der Plasmaquelle ober- bzw. unterseitig innerhalb der Kammer. Kathode und Anode sind mithin einander gegenüberliegend ausgebildet, wobei die Kathode bevorzugterweise im Bereich der Decke und die Anode im Bereich des Bodens der Behandlungskammer angeordnet ist. Um den effektiv nutzbaren Behandlungsraum innerhalb der Behandlungskammer möglichst groß auszubilden, sind die Kathode und die Anode außermittig, das heißt im Bereich der Seitenwand des Behandlungsraums anzuordnen. Bei einer solchen Anordnung von Kathode und Anode bildet sich die Plasmaquelle zwischen der Halteeinrichtung für die zu behandelnden Werkstücke einerseits und der Kammerseitenwand andererseits aus, wobei die Plasmaquelle radial nach innen in Richtung auf die von der Halteeinrichtung getragenen Werkstücke einwirkt. Erzielt wird durch eine solche Ausgestaltung ein im Verhältnis zur Größe der Vorrichtung großer Nutzraum innerhalb der Behandlungskammer, der die Behandlung auch großer Werkstücke ermöglicht.

Gemäß einem weiteren Merkmal der Erfindung ist vorgesehen, daß die Kathode und die Anode innerhalb der Kammer derart angeordnet sind, daß sich der zwischen Kathode und Anode ausbildende Elektronenstrahl parallel zur Rotationsachse der Halteeinrichtung erstreckt. Erreicht wird hierdurch eine besonders platzsparende Anordnung, so daß der von der Behandlungskammer zur Verfügung gestellte Raum optimal genutzt werden kann. Unterstützt wird die platzsparende Anordnung zudem dadurch, daß die Kathoden-Anoden-Anordnung möglichst nahe der Kammerseitenwand angeordnet ist, wobei der Abstand zwischen Halteeinrichtung und Elektronenstrahl kleiner als der Abstand zwischen Kammerwand und Elektronenstrahl ist. Dabei beträgt der Abstand zwischen Halteeinrichtung und Elektronenstrahl weniger als 20 cm, vorzugsweise weniger als 10 cm, mehr bevorzugt weniger als 7 cm. Diese nahe Nebenordnung ermöglicht eine hohe Plasmadichte an den Substraten, d.h. den zu behandelnden Werkstücken.

Die parallele Ausrichtung des Elektronenstrahls ist mit Blick auf das wunschgemäß zu erzielende Behandlungsergebnis nicht zwingend, vielmehr sind auch andere Anordnungen von Kathode und Anode möglich. So können die Kathode und die Anode gemäß einer alternativen Ausführungsform der Erfindung innerhalb der Kammer derart angeordnet sein, daß sich der zwischen Kathode und Anode ausbildende Elektronenstrahl quer zur Rotationsachse der Halteeinrichtung erstreckt. Erreicht werden kann eine solche Ausbildung des Elektronenstrahls beispielsweise dadurch, daß Kathode und Anode in horizontaler Richtung beabstandet voneinander angeordnet sind. Der sich zwischen Kathode und Anode ausbildende Elektronenstrahl erstreckt sich sodann diagonal durch den von der Behandlungskammer bereitgestellten Behandlungsraum, das heißt quer zur Rotationsachse der Halteeinrichtung.

Der Abstand zwischen Anode und Halteeinrichtung beträgt gemäß einem weiteren Merkmal der Erfindung 0,5 cm bis 3,5 cm, vorzugsweise 1,5 cm bis 2,5 cm. Der Abstand zwischen Kathode und Halteeinrichtung kann zwischen 1,0 cm und 7,5 cm, vorzugsweise zwischen 1,5 cm und 5,5 cm, variieren.

Bevorzugterweise ist die Halteeinrichtung, die als Traggerüst, Tisch oder dergleichen ausgebildet sein kann, mittig innerhalb der Bearbeitungskammer angeordnet, so dass der Abstand zwischen Halteeinrichtung einerseits und vorgesehenen Quellen andererseits jeweils gleich groß ist. Zwecks Änderung des Abstands können die Positionen der jeweiligen Quellen vorzugsweise wahlweise veränderbar, d.h. einstellbar ausgebildet sein. Die zu behandelnden Werkstücke können vertikal oder horizontal ausgerichtet von der Halteeinrichtung aufgenommen werden. Bevorzugt ist eine vertikale Ausrichtung, gemäß welcher die Werkstücke parallel zur Erstreckungsvorrichtung der Plasmaquelle ausgerichtet sind, doch kann auch eine solche Anordnung der die Plasmaquelle bildenden Kathoden-Anoden-Anordnung vorgesehen sein, gemäß welcher sich die Plasmaquelle auch bei einer horizontalen Ausrichtung der zu behandelnden Werkstücke im wesentlichen entlang dieser erstreckt. Ferner ist auch eine solche Kathoden-Anoden-Anordnung möglich, gemäß welcher der Plasmastrahl in einer Art Diagonalanordnung quer durch den Substrathalter (Halteeinrichtung) gelenkt wird.

Da die Kathoden-Anoden-Anordnung gemäß der Erfindung verhältnismäßig nahe der Halteeinrichtung und damit den von der Halteeinrichtung getragenen Werkstücken nebengeordnet ist, besteht die Gefahr einer ungewollten Lichtbogenzündung auf den zu behandelnden Werkstücken. Um dies auszuschließen und die Werkstücke vor einer unbeabsichtigten Lichtbogenzündung zu schützen, ist vorgesehen, daß die Kathode und die Anode an eine gemeinsame Stromquelle angeschlossen sind, wobei zwischen Kathode einerseits und Stromquelle andererseits ein Stromunterbrecher, vorzugsweise in Form einer schnell schaltbaren Schalteinrichtung, angeordnet ist. Der Stromunterbrecher sorgt dafür, daß der Plasmaquellenstrom sofort abgeschaltet wird, sobald auf den zu behandelnden Werkstücken eine ungewollte Bogenentladung entsteht. Damit der Plasmaquellenstrom nicht zu lange unterbrochen wird, wird die Plasmaquelle über eine Hochspannungsentladung, gegebenenfalls unterstützt von einer kurzfristigen Druckerhöhung innerhalb der Bearbeitungskammer, gezündet.

Gemäß einem weiteren Merkmal der Erfindung ist die Halteeinrichtung an eine Stromversorgung angeschlossen, wobei der negative Pol der Stromversorgung an der Halteeinrichtung anliegt und wobei zwischen Halteeinrichtung und Stromversorgung eine Spannungs- und/oder Strommeßeinheit angeordnet ist. Sinn und Zweck der Spannungs- und/oder Strommeßeinheit ist es, an der Halteeinrichtung in Folge von ungewollten Bogenentladungen auf den zu behandelnden Werkstücken auftretende Spannungs- und/oder Stromänderungen zu detektieren. Die Spannungs- und/oder Strommeßeinheit steht mit dem Stromunterbrecher des Kathoden-Anoden-Stromkreises in kommunikationstechnischer Verbindung, so daß dieser in Abhängigkeit des von der Spannungs- und/oder Strommeßeinheit detektierten Signals geschaltet werden kann. Vorgesehen ist zu diesem Zweck eine Steuerelektronik, die mittels der Spannungs- und/oder Strommeßeinheit an der Halteeinrichtung auftretende bestimmte Spannungs- und/oder Stromänderungen mißt und zwecks Unterbrechung des Kathoden-Anoden-Stromkreises ein der Messung entsprechendes Signal an den Stromunterbrecher des Kathoden-Anoden-Stromkreises abgibt. Gewährleistet wird auf diese Weise, daß der Plasmaquellenstrom automatisch unterbrochen wird, sobald es auf den zu behandelnden Werkstücken zu einer ungewollten Lichtbogenzündung kommt. Um einer Neuzündung eines Lichtbogens, gespeist von der Plasmastromversorgung, vorzubeugen, ist eine möglichst kurze Reaktionszeit der Steuerelektronik vorzusehen. Vorzugsweise weist die Steuerelektronik daher eine Reaktionszeit von 20 µsec - 250 µsec, vorzugsweise von 10 µsec - 100 µsec auf. Die Abschaltdauer der Biasspannung sollte hinreichend groß sein, damit eine Neuzündung des Lichtbogens auf die Substrate (Werkstücke) vermieden werden kann. Das bedeutet, daß die Abschaltdauer in einem Bereich von 10 msec bis 100 msec liegen sollte, wobei die Abschaltdauer bevorzugter Weise so klein wie möglich gewählt werden sollte, um die Prozeßzeit nicht unnötig zu verlängern.

Die erfindungsgemäß eingesetzte Plasmaquelle, die als Elektronenstrahlverdampfer bezeichnet werden kann, ist vorzugsweise als Heiß- oder Kaltkathodenquelle ausgebildet.

Gemäß einem weiteren Vorschlag der Erfindung verfügt die Vorrichtung über wenigstens eine im Bereich der Kammerwand angeordnete Verdampferquelle. Da die die Plasmaquelle bildende Kathoden-Anoden-Anordnung innerhalb der Behandlungskammer angeordnet ist, kann die wenigstens eine Verdampferquelle an beliebiger Stelle umfangsseitig sowohl innerhalb als auch außerhalb der Behandlungskammer angeordnet sein. Vorzugsweise verfügt die Vorrichtung über eine Vielzahl von Verdampferquellen, die gleich beabstandet voneinander an der Seitenwand der Behandlungskammer angeordnet sein können. Dabei ist der Abstand zwischen Verdampferquelle und Halteeinrichtung im wesentlichen gleich dem Abstand zwischen Halteeinrichtung und Kammerwand.

Verfahrensseitig wird zur **Lösung** der vorgenannten Aufgabe vorgeschlagen ein Verfahren zur Plasma- und/oder Beschichtungsbehandlung von Werkstücken in einer evakuierbaren Kammer mit einer innerhalb der evakuierbaren Kammer drehbar angeordneten Halteeinrichtung für die zu behandelnden Werkstücke, dadurch gekennzeichnet, daß durch eine innerhalb der Kammer angeordnete und eine Plasmaquelle bildende Kathoden-Anoden-Anordnung ein Elektronenstrahl zwischen Kathode und Anode erzeugt wird, wobei der Kathoden-Anoden-Stromkreis unterbrochen wird, sobald eine bestimmte Spannungs- und/oder Stromabweichung zwischen der an den negativen Pol einer Stromversorgung angeschlossenen Halteeinrichtung und der Stromversorgung detektiert wird.

Gemäß dieser erfindungsgemäßen Verfahrensdurchführung ist vorgesehen, daß es zu einer sofortigen Unterbrechung des Plasmaquellenstromkreises kommt, sobald sich durch eine ungewollte Lichtbogenzündung auf den zu behandelnden Werkstücken verursacht eine bestimmte Spannungs- und/oder Stromabweichung zwischen der an den negativen Pol einer Stromversorgung angeschlossenen Halteeinrichtung für die zu behandelnden Werkstücke und der Stromversorgung einstellt. Geschützt werden die zu behandelnden Werkstücke durch diese Verfahrensdurchführung vor etwaigen Schäden, hervorgerufen durch ungewollte Lichtbogenzündungen, welche von der Plasmaquelle in Stand gehalten werden.

Damit der Plasmaquellenstrom nach Abschaltung nicht zu lange unterbrochen bleibt, wird gemäß einem weiteren Merkmal der Erfindung vorgeschlagen, daß die Plasmaquelle mittels einer Hochspannungsentladung, beispielsweise in Form eines Funkens, gegebenenfalls unter kurzfristiger Kammerdruckerhöhung, gezündet wird. Hierdurch wird in der Elektronenbahn zwischen Kathode und Anode Plasma erzeugt, infolge dessen sich der Elektronenstrahl auf diesem Pfad ausbildet.

Während des Zündvorgangs der Plasmaquelle wird die an die Halteeinrichtung angeschlossene Stromversorgung unterbrochen, damit die Zündung der Plasmaquelle aufgrund des an der Halteeinrichtung anliegenden negativen Pols nicht beeinträchtigt wird.

Gemäß einem weiteren Merkmal der Erfindung erfolgt zwecks Plasma- und Beschichtungsbehandlung in einem ersten Schritt eine Plasmabehandlung der Werkstücke mit Ladungsträgerbeschuß und in einem zweiten Schritt eine Beschichtung der Werkstücke mittels wenigstens einer an der Kammerwand angeordneten Verdampferquelle, wobei als Ladungsträger Ionen, vorzugsweise Argonionen, verwendet werden. Dabei dient der Schritt der Plasmabehandlung der Reinigung und Erwärmung der zu behandelnden Werkstücke, wohingegen gemäß zweitem Schritt eine Beschichtung der Werkstücke vorgesehen ist, die beispielsweise mittels Magnetronbeschichtungsquellen und/oder Arc-Quellen vorgenommen werden kann. Grundsätzlich lassen sich als Beschichtungsquellen Zerstäubungsquellen oder Arc-Quellen einsetzen. Auch ist der Einsatz von PA-CVD (plasmaunterstütztes Verfahren) möglich, bei dem direkt aus der Gasphase ohne Materialverdampfung von den Kathoden gearbeitet wird.

Weitere Merkmale und Vorteile der Erfindung ergeben sich aus der Beschreibung anhand der nachfolgenden Figuren. Dabei zeigen:
- Fig. 1: in einer schematischen Darstellung eine erste Ausführungsform der Erfindung und
- Fig. 2: in einer schematischen Darstellung eine zweite Ausführungsform der Erfindung.

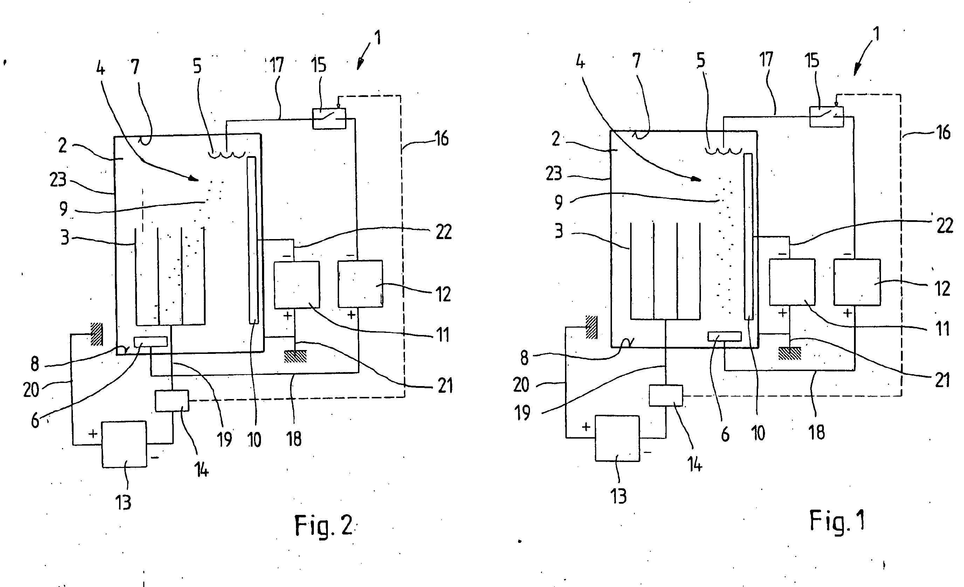

Die Fign. 1 und 2 zeigen in schematischer Darstellung eine erste und eine zweite Ausführungsform der Erfindung. In den Fign. angegebene gleiche Bezugszeichen identifizieren gleiche Elemente.

Dargestellt in den Fign. 1 und 2 ist die erfindungsgemäße Vorrichtung 1. Diese beinhaltet eine Behandlungskammer 2, innerhalb welcher eine Halteeinrichtung 3 zur Aufnahme der zu behandelnden und in den Fign. nicht dargestellten Werkstücke dient. Die Halteeinrichtung 3 weist vorzugsweise die Form eines Gestells auf und ist rotierbar innerhalb der Behandlungskammer 2 angeordnet.

Des weiteren innerhalb der Behandlungskammer 2 angeordnet ist eine Plasmaquelle 4. Gebildet ist die Plasmaquelle 4 durch eine innerhalb der Kammer angeordnete Kathode 5 einerseits und einer Anode 6 andererseits. Der sich zwischen Kathode 5 und Anode 6 bei einer bestimmungsgemäßen Verwendung der Vorrichtung 1 ausbildende Elektronenstrahl 9 erstreckt sich gemäß dem Ausführungsbeispiel nach Fig. 1 parallel zur Drehachse der Halteeinrichtung 3. Gemäß dem Ausführungsbeispiel nach Fig. 2 sind Kathode 5 und Anode 6 derart angeordnet, daß sich der zwischen Kathode 5 und Anode 6 ausbildende Elektronenstrahl 9 quer zur Rotationsachse der Halteeinrichtung 3 erstreckt. Beiden Ausführungsformen ist dabei gemein, daß die Kathode 5 kammeroberseitig 7 und die Anode 6 kammerunterseitig 8 angeordnet ist.

Mit Blick auf das Ausführungsbeispiel nach Fig. 1 ist zu erkennen, daß der zwischen Kathode 5 und Anode 6 gebildete Elektronenstrahl 9 zwischen Halteeinrichtung 3 einerseits und seitlicher Kammerwand 23 andererseits angeordnet ist. Um einen möglichst großen nutzbaren Raum innerhalb der Behandlungskammer 2 zu schaffen, ist der Abstand zwischen Halteeinrichtung 3 und Elektronenstrahl 9 kleiner als der Abstand zwischen Kammerwand 23 und Elektronenstrahl 9 ausgebildet. Bevorzugterweise beträgt der Abstand zwischen Halteeinrichtung 3 und Elektronenstrahl 9 weniger als 20 cm, vorzugsweise weniger als 10 cm.

Wie den Fign. 1 und 2 des weiteren entnommen werden kann, ist innerhalb der Behandlungskammer 2 des weiteren eine Verdampferquelle 10 angeordnet, die in der seitlichen Kammerwand 23 positioniert ist. Der Abstand zwischen Verdampferquelle 10 und Halteeinrichtung 3 ist dabei im wesentlichen gleich dem Abstand zwischen Halteeinrichtung 3 und Kammerwand 23.

Die die Plasmaquelle 4 bildende Kathoden-Anoden-Anordnung wird mittels einer Stromquelle 12 gespeist. Dabei liegt der negative Pol 17 der Stromquelle 12 an der Kathode 5 und der positive Pol 18 der Stromquelle 12 an der Anode 6 an. Bevorzugterweise wird die als Heiß- oder Kaltkathodenquelle ausgebildete Plasmaquelle 4 mittels Gleichstrom betrieben, weshalb die Stromquelle 12 eine Gleichstromquelle ist.

Die Verdampferquelle 10 wird mittels einer Stromquelle 11 gespeist, wobei der negative Pol 22 der Stromquelle 11 an der Verdampferquelle 10 und der positive Pol 21 der Stromquelle 11 an der Behandlungskammer 2 anliegt.

Des weiteren vorgesehen ist eine Stromversorgung 13, wobei der negative Pol 19 der Stromversorgung 13 an der Halteeinrichtung 3 anliegt. Der positive Pol 20 der Stromversorgung 13 steht mit der Behandlungskammer 2 in Verbindung.

Zwischen Kathode 5 einerseits und Stromquelle 12 andererseits ist ein Stromunterbrecher 15 vorgesehen, der vorzugsweise die Form einer schnell schaltbaren Schaltereinrichtung aufweist, wobei Stromquelle 12 und Stromunterbrecher 15 integral ausgebildet sein können. Der Stromunterbrecher 15 steht kommunikationstechnisch mit einer Spannungs- und/oder Strommeßeinheit 14 in Verbindung, die zwischen Halteeinrichtung 3 und Stromversorgung 13 angeordnet und bevorzugter Weise in die Biasversorgung integriert ist. Vorgesehen ist des weiteren eine in den Fign. nicht gezeigte Steuerelektronik, die mittels der Spannungs- und/oder Strommeßeinheit 14 an der Halteeinrichtung 3 auftretende Spannungs- und/oder Stromänderungen mißt und zwecks Unterbrechung des Kathoden-Anoden-Stromkreises ein der Messung entsprechendes Signal 16 an den Stromunterbrecher 15 des Kathoden-Anoden-Stromkreises abgibt.

Die Plasmaquelle 4 wird mittels des Elektronenstrahls 9 ausgebildet, welcher bei Einschaltung der Stromquelle 12 zwischen Kathode 5 und Anode 6 verläuft. Wie Fig. 1 zeigt, kann die Position von Kathode 5 und Anode 6 derart gewählt werden, daß sich der Elektronenstrahl 9 seitlich der Halteeinrichtung 3 erstreckt, wobei die Kathode 5 oberseitig, das heißt im Bereich des Daches der Behandlungskammer 2 und die Anode 6 unterseitig, das heißt im Bereich des Bodens der Behandlungskammer 2 angeordnet sind. Auch ist eine andere Ausrichtung des Elektronenstrahls 9 möglich, wie beispielhaft Fig. 2 zeigt, gemäß welcher die Kathode 5 und die Anode 6 derart angeordnet sind, daß der sich zwischen ihnen ausbildende Elektronenstrahl 9 diagonal durch die Behandlungskammer 2, das heißt quer zur Rotationsachse der Halteeinrichtung 3 erstreckt. Unabhängig von der Anordnung der Kathode 5 bzw. der Anode 6 kann der Elektronenstrahl 19 beispielsweise unter Verwendung einer ringförmigen Anode konisch ausgebildet sein. Auch ist es möglich den Elektronenstrahl 19 im Bereich seiner Mitte breiter als in seinen Endbereichen auszubilden.

Bevorzugterweise ist der Abstand zwischen Halteeinrichtung 3 und Elektronenstrahl 9 wesentlich geringer als 20 cm, vorzugsweise geringer als 10 cm, mehr bevorzugt geringer als 7 cm. Durch den Elektronenstrahl 9 werden Gasionen erzeugt, bevorzugterweise Argongasionen für den Fall, daß die Plasmaquelle zum Ätzen verwendet wird, damit im Plasma die erforderliche physikalische Eigenschaft der Quasineutralität gewährleistet wird. Die Ätzwirkung kann beim Ätzvorgang durch den Elektronenstrom 9 der Plasmaquelle über die Einstellung der Plasmaquellenstromversorgung einerseits und durch die an der Halteeinrichtung 3 angelegte Spannung andererseits beeinflußt werden. Die Elektronenstromdichte bestimmt die Argongasdichte, wohingegen die an die Halteeinrichtung 3 angelegte Spannung bestimmt, mit welcher Energie Argongasionen aus der Plasmasäule auf die von der Halteeinrichtung 3 getragenen Werkstücke aufschlagen. Als Plasmaquellenstromversorgung wird eine DC-Versorgung eingesetzt, wobei der positive Pol 18 an der Anode 6 und der negative Pol 17 an der Kathode 5 angeschlossen ist. Auch ist es möglich, eine mit gepulstem Gleichstrom oder eine mit Wechselstrom gespeiste Plasmaquelle zu verwenden, wobei in diesem Fall Anode 6 und Kathode 5 abwechselnd angesteuert werden.

Die Kathode 5 besteht im Falle der Stromspeisung mittels Gleichstrom vorzugsweise aus einer Heißkathodenquelle, welche über einen Heizdraht zur Erzeugung einer Elektronenemission verfügt. Nach Aufheizen des Heiz- oder Glühdrahtes wird mittels der Gleichspannungsquelle eine Niedervoltbogenentladung zwischen dem als Kathode 5 dienenden Glühdraht und der Anode 6 der Plasmaquelle gezündet. Zur Zündung kann ein Hilfskreis verwendet werden, welcher eine Hilfsentladung freisetzt, die zusätzliches Plasma in der direkten Nähe des Pfades des Elektronenstrahls 9 zwischen Kathode 5 und Anode 6 zündet.

Sowohl die Kathode 5 als auch die Anode 6 sind isoliert und schwebend gegenüber dem Erdpotential angeordnet. Damit der Elektronenstrahl gesteuert werden kann, das heißt sich nicht über parasitäre Wege ausbildet, welche von den zu behandelnden Werkstücken weiter entfernt sind, z. B. um örtliche Entladungskonzentrationen zu vermeiden, was über die Höhe der zu behandelnden Werkstücke zu ungleichmäßigen Plasmaätzungen führen kann, sind die Kathode 5 und die Anode 6 von in den Fign. nicht näher dargestellten Abschirmungen und/oder Isolierungen umgeben.

Der Glüh- oder Heizdraht der Kathode 5 befindet sich üblicherweise im Dach der Behandlungskammer 2 an dessen Oberseite. Die Anode 6 befindet sich üblicherweise der Kathode 5 gegenüberliegend an der Unterseite der Behandlungskammer 2. Zwischen Anode 6 und Kathode 5 bildet sich bei Einschaltung der Stromquelle 12 ein Elektronenstrahl 9 aus, wobei die Energie der Elektronen dazu verwendet wird, aus den über einen in den Fign. nicht dargestellten Gaseinlaß zugeführten Argon-Atomen Argonionen zu bilden. Der Elektronenstrahl 9 bildet mithin eine Argonionenquelle und ist die eigentliche Plasmaquelle 4.

Plasmaquelle 4 und Verdampferquelle 10 sind gleichwirkend radial angeordnet, was im Sinne der Erfindung bedeutet, daß die Wirkung der Plasmaquelle 4 als auch die Wirkung der Verdampferquelle 10 in Richtung der Halteeinrichtung 3 und den davon getragenen Werkstücken wirkt.

Zum Schutz der Werkstücke ist es notwendig, beim Entstehen einer ungewollten Bogenentladung auf den Werkstücken die Plasmaquellenstromversorgung sofort abzuschalten, um das Risiko zu vermeiden, daß ein auf den Werkstücken gezündeter Lichtbogen, der über die Energie der Gleichspannungsversorgung der Plasmaquelle 4 gespeist wird, weiterläuft. Zu diesem Zweck verfügt die Stromversorgung für die Plasmaquelle über einen Stromunterbrecher 15, wie vorstehend beschrieben.

Damit der Plasmaquellenstrom nicht zu lange unterbrochen bleibt, wird die Plasmaquelle 4 über eine Hochspannungsentladung, gegebenenfalls unterstützt von einer kurzfristigen Druckerhöhung innerhalb der Bearbeitungskammer 2, gezündet. Während des Zündvorgangs wird die an die Halteeinrichtung 3 angelegte Spannung unterbrochen, damit die Negativschaltung der Halteeinrichtung 3 einem Zündvorgang nicht hinderlich entgegensteht.

Um einen stabilen Betrieb der Plasmaquelle 4 gewährleisten zu können, ist es erforderlich, daß der Elektronenstrahl 9 durch geeignete Maßnahmen von der Kammerwand 23 getrennt, das heißt isoliert ist. Geeignete Maßnahmen in diesem Sinne können sein, das Anbringen von (elektrischen) Abschirmungen zwischen Elektronenstrahl 9 und Kammerwand 23, sowie zwischen Anode 6 und Kammerwand 23, sowie zwischen Anode 6 und Unterseite der Halteeinrichtung 3.

Bei aktiver Plasmaquelle 4 und gleichzeitiger Anlegung einer Spannung an die Halteeinrichtung 3 besteht aufgrund der Nahenebenordnung von Plasmaquelle 4, das heißt Elektronenstrahl 9, und Halteeinrichtung 3, das heißt den von der Halteeinrichtung 3 getragenen Werkstücken, die Möglichkeit, daß ungewollt auf den Werkstücken ein Lichtbogen gezündet wird, der an den Werkstücken zu Schäden führen kann. Um eine solche Beschädigung der Werkstücke wirkungsvoll ausschließen zu können, verfügt die erfindungsgemäße Vorrichtung über eine Arcerkennungseinheit in Form einer Spannungs- und/oder Strommeßeinheit 14, die im Stromkreis zwischen Halteeinrichtung 3 und Stromversorgung 13 angeordnet ist.

Die Spannungs- und/oder Strommeßeinheit 14 detektiert durch ungewollte Lichtbogenzündungen auf den Werkstücken verursachte bestimmte Spannungs- und/oder Stromabweichung und gibt über eine entsprechende Steuerelektronik ein der Messung entsprechendes Signal 16 an den Stromunterbrecher 15 der Plasmaquellenstromversorgung weiter, so daß bei Auftreten einer ungewollten Lichtbogenentladung diese erkannt und die Plasmaquellenstromversorgung so schnell wie möglich abgeschaltet werden kann. Die Arcerkennung der Arcerkennungseinheit, sprich der Spannungs- und/oder Strommeßeinheit 14 sollte möglichst schnell sein, damit der Neuzündung eines Lichtbogens, gespeist von der Plasmaquellenstromversorgung, vorgebeugt werden kann. Die Wartezeit sollte vorzugsweise im Bereich von 100 µsec bis 200 µsec, vorzugsweise unterhalb von 150 µsec liegen, wobei die Einstellung der Wartezeit, bis die Biasspannung wieder angelegt wird, so zu wählen ist, dass sie groß genug ist, um eine unerwünschte Neuzündung zu vermeiden. Solange die Wartezeit andauert, ist die Plasmaquelle elektronisch abgeschaltet, wie vorstehend beschrieben, wobei die Abschaltung nach ca. 50 µsec nach Detektion des Arc erfolgt. Bei Erkennung eines Lichtbogens am Substrathalter wird die Biasspannung gleichfalls so schnell wie möglich abgeschaltet. Gleichzeitig mit der Abschaltung der Biasspannung - gegebenenfalls auch etwas später - wird der Plasmaquellenstrom ausgeschaltet, um eine Neuzündung des Lichtbogens am Substrat (Werkstück) zu vermeiden.

### Bezugszeichenliste

1 Vorrichtung
2 Kammer
3 Halteeinrichtung
4 Plasmaquelle
5 Kathode
6 Anode
7 Kammeroberseite
8 Kammerunterseite
9 Elektronenstrahl
10 Verdampferquelle
11 Stromquelle
12 Stromquelle
13 Stromversorgung
14 Spannungs- oder Strommeßeinheit
15 Stromunterbrecher
16 Signal
17 negativer Pol
18 positiver Pol
19 negativer Pol
20 positiver Pol
21 positiver Pol
22 negativer Pol
23 Kammerwand

## Patentansprüche

1. Vorrichtung zur Plasma- und/oder Beschichtungsbehandlung von Werkstücken mit einer evakuierbaren Kammer (2), einer innerhalb der Kammer (2) drehbar angeordneten Halteeinrichtung (3) für die zu behandelnden Werkstücke und einer Plasmaquelle (4), wobei die Plasmaquelle (4) innerhalb der Kammer (2) angeordnet ist, zu welchem Zweck die mindestens eine Kathode (5) und die mindestens eine Anode (6) der Plasmaquelle (4) ober- bzw. unterseitig (7, 8) innerhalb der Kammer (2) angeordnet sind,
**dadurch gekennzeichnet,**
**daß** die Kathode (5) und die Anode (6) an eine gemeinsame Stromquelle (12) angeschlossen sind, wobei zur Unterbrechung des Kathoden-Anoden-Stromkreises ein Stromunterbrecher (15) vorgesehen ist.

2. Vorrichtung nach Anspruch 1, **dadurch gekennzeichnet, daß** der Stromunterbrecher (15) zwischen Kathode (5) einerseits und Stromquelle (12) andererseits angeordnet ist.

3. Vorrichtung nach Anspruch 1 oder 2, **dadurch gekennzeichnet, daß** der Stromunterbrecher (15) eine schnell schaltbare Schaltereinrichtung ist.

4. Vorrichtung nach Anspruch 1, 2 oder 3, **dadurch gekennzeichnet, daß** die Kathode (5) und die Anode (6) innerhalb der Kammer (2) derart angeordnet sind, daß sich der zwischen Kathode (5) und Anode (6) ausbildende Elektronenstrahl (9) parallel zur Rotationsachse der Halteeinrichtung (3) erstreckt.

5. Vorrichtung nach Anspruch 4, **dadurch gekennzeichnet, daß** der Abstand zwischen Halteeinrichtung (3) und Elektronenstrahl (9) kleiner als der Abstand zwischen Kammerwand (23) und Elektronenstrahl (9) ist.

6. Vorrichtung nach Anspruch 5, **dadurch gekennzeichnet, daß** der Abstand zwischen Halteeinrichtung (3) und Elektronenstrahl (9) kleiner als 20 cm ist.

7. Vorrichtung nach Anspruch 1, 2 oder 3, **dadurch gekennzeichnet, daß** die Kathode (5) und die Anode (6) innerhalb der Kammer (2) derart angeordnet sind, daß sich der zwischen Kathode (5) und Anode (6) ausbildende Elektronenstrahl (9) quer zur Rotationsachse der Halteeinrichtung (3) erstreckt.

8. Vorrichtung nach einem der vorhergehenden Ansprüche, **dadurch gekennzeichnet, daß** der Abstand zwischen Anode (6) und Halteeinrichtung (3) 0,5 cm bis 3,5 cm beträgt.

9. Vorrichtung nach einem der vorhergehenden Ansprüche, **dadurch gekennzeichnet, daß** der Abstand zwischen Kathode (5) und Halteeinrichtung (3) 1,0 cm bis 7,5 cm beträgt.

10. Vorrichtung nach einem der vorhergehenden Ansprüche, **dadurch gekennzeichnet, daß** die Stromquelle (12) eine Gleichstromquelle ist.

11. Vorrichtung nach einem der vorhergehenden Ansprüche, **dadurch gekennzeichnet, daß** die Halteeinrichtung (3) an eine Stromversorgung (13) angeschlossen ist, wobei der negative Pol (19) der Stromversorgung (13) an der Halteeinrichtung (3) anliegt und wobei zwischen Halteeinrichtung (3) und Stromversorgung (13) eine Spannungs- und/oder Strommeßeinheit (14) angeordnet ist.

12. Vorrichtung nach Anspruch 11, **dadurch gekennzeichnet, daß** die Spannungs-und/oder Strommeßeinheit (14) mit dem Stromunterbrecher (15) des Kathoden-Anoden-Stromkreises in kommunikationstechnischer Verbindung (16) steht.

13. Vorrichtung nach Anspruch 11 oder 12, **gekennzeichnet durch** eine Steuerelektronik, die mittels der Spannungs- und/oder Strommeßeinheit (14) an der Halteeinrichtung (3) auftretende Spannungs- und/oder Stromänderungen mißt und zwecks Unterbrechung des Kathoden-Anoden-Stromkreises ein der Messung entsprechendes Signal an den Stromunterbrecher (15) des Kathoden-Anoden-Stromkreises abgibt.

14. Vorrichtung nach Anspruch 13, **dadurch gekennzeichnet, daß** die Steuerelektronik eine Reaktionszeit von unter 50 µsec aufweist.

15. Vorrichtung nach einem der vorhergehenden Ansprüche, **dadurch gekennzeichnet, daß** die Plasmaquelle (4) eine Heiß- oder Kaltkathodenquelle ist.

16. Vorrichtung nach einem der vorhergehenden Ansprüche, **gekennzeichnet durch** wenigstens eine im Bereich der Kammerwand (23) angeordnete Verdampferquelle (10).

17. Vorrichtung nach Anspruch 16, **dadurch gekennzeichnet, daß** der Abstand zwischen Verdampferquelle (10) und Halteeinrichtung (3) im wesentlichen gleich dem Abstand zwischen Halteeinrichtung (3) und Kammerwand (23) ist.

18. Verfahren zur Plasma- und/oder Beschichtungsbehandlung von Werkstücken in einer evakuierbaren Kammer (2) mit einer innerhalb der evakuierbaren Kammer (2) drehbar angeordneten Halteeinrichtung (3) für die zu behandelnden Werkstücke, **dadurch gekennzeichnet, daß** durch eine innerhalb der Kammer (2) angeordnete und eine Plasmaquelle (4) bildende Kathoden-Anoden-Anordnung ein Elektronenstrahl (9) zwischen Kathode (5) und Anode (6) erzeugt wird, wobei der Kathoden-Anoden-Stromkreis unterbrochen wird, sobald ein Spannungs- oder Strompotential zwischen der an den negativen Pol (19) einer Stromversorgung (13) angeschlossenene Halteeinrichtung (3) und der Stromversorgung (13) detektiert wird.

19. Verfahren nach Anspruch 18, **dadurch gekennzeichnet, daß** die Plasmaquelle (4) mittels einer Hochspannungsentladung gezündet wird.

20. Verfahren nach einem der Ansprüche 18 oder 19, **dadurch gekennzeichnet, daß** die Plasmaquelle (4) unter kurzfristiger Kammerdruckerhöhung gezündet wird.

21. Verfahren nach einem der Ansprüche 18 bis 20, **dadurch gekennzeichnet, daß** während des Zündvorganges der Plasmaquelle (4) die an die Halteeinrichtung (3) angeschlossene Stromversorgung (13) unterbrochen wird.

22. Verfahren nach einem der Ansprüche 18 bis 21, **dadurch gekennzeichnet, daß** in einem ersten Schritt eine Plasmabehandlung der Werkstücke mit Ladungsträgerbeschuß und in einem zweiten Schritt eine Beschichtung der Werkstücke mittels wenigstens einer an der Kammerwand (23) angeordneten Verdampferquelle (10) erfolgt, wobei als Ladungsträger Ionen verwendet werden.

## Claims

1. A device for the plasma and/or coating treatment of workpieces comprising a chamber (2), which can be evacuated, a holding device (3) for the workpieces, which are to be treated, which is arranged within the chamber (2) to as to be capable of being rotated, and a plasma source (4), wherein the plasma source (4) is arranged within the chamber (2), for the purpose of which the at least one cathode (5) and the at least one anode (6) of the plasma source (4) are arranged within the chamber (2) on the upper or lower side (7, 8), respectively,
**characterized in**
**that** the cathode (5) and the anode (6) are connected to a common current source (12), wherein provision is made for a circuit breaker (15) for interrupting the cathode-anode circuit.

2. The device according to claim 1, **characterized in that** the circuit breaker (15) is arranged between cathode (5) on the one side and current source (12) on the other side.

3. The device according to claim 1 or 2, **characterized in that** the circuit breaker (15) is a rapidly switchable switch unit.

4. The device according to claim 1, 2 or 3, **characterized in that** the cathode (5) and the anode (6) are arranged within the chamber (2) in such a manner that the electron beam (9), which forms between cathode (5) and anode (6), extends parallel to the axis of rotation of the holding device (3).

5. The device according to claim 4, **characterized in that** the distance between holding device (3) and electron beam (9) is smaller than the distance between chamber wall (23) and electron beam (9).

6. The device according to claim 5, **characterized in that** the distance between holding device (3) and electron beam (9) is less than 20 cm.

7. The device according to claim 1, 2 or 3, **characterized in that** the cathode (5) and the anode (6) are arranged within the chamber (2) in such a manner that the electrode beam (9), which forms between cathode (5) and anode (6), extends at right angles to the axis of rotation of the holding device (3).

8. The device according to one of the preceding claims, **characterized in that** the distance between anode (6) and holding device (3) is from 0.5 cm to 3.5 cm.

9. The device according to one of the preceding claims, **characterized in that** the distance between cathode (5) and holding device (3) is from 1.0 cm to 7.5 cm.

10. The device according to one of the preceding claims, **characterized in that** the current source (12) is a direct current source.

11. The device according to one of the preceding claims, **characterized in that** the holding device (3) is connected to a power supply (13), wherein the negative pole (19) of the power supply (13) is applied to the holding device (3) and wherein a voltage and/or current measuring unit (14) is arranged between holding device (3) and power supply (13).

12. The device according to claim 11, **characterized in that** the voltage and/or current measuring unit (14) is in connection (16) with the circuit breaker (15) of the cathode-anode circuit in terms of communication.

13. The device according to claim 11 or 12, **characterized in that** a control electronics, which measures voltage and/or current changes occurring on the holding device (3) by means of the voltage and/or current measuring unit (14) and which, for the purpose of interrupting the cathode-anode circuit, emits a signal, which corresponds to the measurement, to the circuit breaker (15) of the cathode-anode circuit.

14. The device according to claim 13, **characterized in that** the control electronics encompasses a reaction time of under 50 µsec.

15. The device according to one of the preceding claims, **characterized in that** the plasma source (4) is a hot or cold cathode source.

16. The device according to one of the preceding claims, **characterized by** at least one vaporization source (10), which is arranged in the area of the chamber wall (23).

17. The device according to claim 16, **characterized in that** the distance between vaporization source (10) and holding device (3) is substantially the same as the distance between holding device (3) and chamber wall (23).

18. A method for the plasma and/or coating treatment of workpieces in a chamber (2), which can be evacuated, comprising a holding device (3) for the workpieces, which are to be treated, which is arranged within the chamber (2), which can be evacuated, so as to be capable of being rotated, **characterized in that** an electron beam (9) is generated between cathode (5) and anode (6) by means of a cathode-anode arrangement, which is arranged within the chamber (2) and which forms a plasma source (4), wherein the cathode-anode circuit is interrupted as soon as a voltage or current potential is detected between the holding device (3), which is connected to the negative pole (19) of a power supply (13) and the power supply (13).

19. The method according to claim 18, **characterized in that** the plasma source (4) is ignited by means of a high voltage discharge.

20. The method according to one of claims 18 or 19, **characterized in that** the plasma source (4) is ignited under a short-term chamber pressure increase.

21. The method according to one of claims 18 to 20, **characterized in that** the power supply (13), which is connected to the holding device (3) during the ignition process of the plasma source (4), is interrupted.

22. The method according to one of claims 18 to 21, **characterized in that** a plasma treatment of the workpieces is carried out in a first step by means of charge carrier bombardment and that a coating of the workpieces is carried out in a second step by means of at least one vaporization source (10), which is arranged at the chamber wall (23), wherein ions are used as charge carriers.

## Revendications

1. Dispositif pour le traitement de revêtement et/ou au plasma de pièces usinées, avec une chambre évacuable (2), un dispositif de maintien (3) disposé de façon rotative à l'intérieur de la chambre (2) pour les pièces usinées à traiter, et une source de plasma (4), la source de plasma (4) étant disposée à l'intérieur de la chambre (2), l'au moins une cathode (5) et l'au moins une anode (6) de la source de plasma (4) étant à cette fin disposées du côté supérieur ou du côté inférieur (7, 8) à l'intérieur de la chambre (2),
**caractérisé en ce que**
la cathode (5) et l'anode (6) étant connectées à une source de courant commune (12), un interrupteur de courant (15) étant prévu pour l'interruption du circuit électrique entre cathode et anode.

2. Dispositif selon la revendication 1, **caractérisé en ce que** l'interrupteur de courant (15) est disposé entre la cathode (5) d'une part et la source de courant (12) d'autre part.

3. Dispositif selon l'une des revendications 1,
**caractérisé en ce que** l'interrupteur de courant (15) est un commutateur rapide.

4. Dispositif selon l'une des revendications 1, 2 ou 3, **caractérisé en ce que** la cathode (5) et l'anode (6) sont disposées de telle manière à l'intérieur de la chambre (2), que le faisceau d'électrons (9) formé entre la cathode (5) et l'anode (6) s'étend parallèlement à l'axe de rotation du dispositif de maintien (3).

5. Dispositif selon la revendication 4, **caractérisé en ce que** l'espacement entre le dispositif de maintien (3) et le faisceau d'électrons (9) est inférieur à l'espacement entre la paroi de chambre (23) et le faisceau d'électrons (9).

6. Dispositif selon la revendication 5, **caractérisé en ce que** l'espacement entre le dispositif de maintien (3) et le faisceau d'électrons (9) est inférieur à 20 cm.

7. Dispositif de maintien selon la revendication 1, 2 ou 3, **caractérisé en ce que** la cathode (5) et l'anode (6) sont disposées de telle manière à l'intérieur de la chambre (2), que le faisceau d'électrons (9) formé entre la cathode (5) et l'anode (6) s'étend perpendiculairement à l'axe de rotation du dispositif de maintien (3).

8. Dispositif selon l'une des revendications précédentes, **caractérisé en ce que** l'espacement entre l'anode (6) et le dispositif de maintien (3) mesure entre 0,5 et 3,5 cm.

9. Dispositif selon l'une des revendications précédentes, **caractérisé en ce que** l'espacement entre la cathode (5) et le dispositif de maintien (3) mesure entre 1,0 et 7,5 cm.

10. Dispositif selon l'une des revendications précédentes, **caractérisé en ce que** la source de courant (12) est une source de courant continu.

11. Dispositif selon l'une des revendications précédentes, **caractérisé en ce que** le dispositif de maintien (3) est raccordé à une alimentation électrique (13), le pôle négatif (19) de l'alimentation électrique (13) s'appliquant sur le dispositif de maintien (3), et une unité de mesure de courant et/ou de tension (14) étant disposée entre le dispositif de maintien (3) et l'alimentation électrique (13).

12. Dispositif selon la revendication 11, **caractérisé en ce que** l'unité de mesure de courant et/ou de tension (14) est se trouve en liaison technique avec l'interrupteur de courant (15) du circuit électrique cathode-anode.

13. Dispositif selon l'une des revendications 11 ou 12, **caractérisé par** une électronique de commande mesurant les variations de courant et/ou de tension au niveau du dispositif de maintien (3), au moyen de l'unité de mesure de courant et/ou de tension (14), et envoyant un signal correspondant à la mesure vers l'interrupteur de courant (15) du circuit électrique cathode-anode, en vue de l'interruption du circuit électrique cathode-anode.

14. Dispositif selon la revendication 13, **caractérisé en ce que** l'électronique de commande présente un temps de réaction inférieur à 50 µsec.

15. Dispositif selon l'une des revendications précédentes, **caractérisé en ce que** la source de plasma (4) est une source de cathode chaude ou froide.

16. Dispositif selon l'une des revendications précédentes, **caractérisé par** au moins une source d'évaporateur (10) disposée dans la région de la paroi de chambre (23).

17. Dispositif selon la revendication 16, **caractérisé en ce que** l'espacement entre la source d'évaporateur (10) et le dispositif de maintien (3) est quasiment identique à l'espacement entre le dispositif de maintien (3) et la paroi de chambre (23).

18. Procédé pour le traitement de revêtement et/ou au plasma de pièces usinées dans une chambre évacuable (2), avec un dispositif de maintien (3) disposé de façon rotative à l'intérieur de la chambre évacuable (2), pour les pièces usinées à traiter, **caractérisé en ce qu'**un ensemble cathode-anode formant une source de plasma (4) et disposée à l'intérieur de la chambre (2) permet de produire un faisceau d'électrons (9) entre la cathode (5) et l'anode (6), le circuit électrique cathode-anode étant interrompu dès qu'un potentiel de courant ou de tension est détecté entre une alimentation électrique (13) et le dispositif de maintien (3) raccordé au pôle négatif (19) de l'alimentation électrique (13).

19. Procédé selon la revendication 18, **caractérisé en ce que** la source de plasma (4) est allumée au moyen d'une décharge à haute tension.

20. Procédé selon l'une des revendications 18 ou 19, **caractérisé en ce que** la source de plasma (4) est allumée avec une brève augmentation de pression dans la chambre.

21. Procédé selon l'une des revendications 18 à 20, **caractérisé en ce que** pendant le procédé d'allumage de la source de plasma (4), l'alimentation électrique (13) raccordée au dispositif de maintien (3) est interrompue.

22. Procédé selon l'une des revendications 18 à 21, **caractérisé en ce qu'**au cours d'une première étape, un traitement au plasma des pièces usinées est effectué avec un bombardement d'un porteur de charge, et au cours d'une deuxième étape, un revêtement des pièces usinées est effectué au moyen d'au moins une source d'évaporateur (10) disposée sur une paroi de chambre (23), les ions étant utilisés comme porteur de charge.
